Europäisches Patentamt

(19) European Patent Office

Office européen des brevets

(11) Publication number: **0 354 131**
A2

## (12) EUROPEAN PATENT APPLICATION

(21) Application number: **89402229.2**

(22) Date of filing: **07.08.89**

(51) Int. Cl.5: **H 01 F 1/11**
H 01 F 1/113, H 05 K 9/00

(30) Priority: **05.08.88 US 228583**

(43) Date of publication of application:
**07.02.90 Bulletin 90/06**

(84) Designated Contracting States:
**AT BE CH DE ES FR GB GR IT LI LU NL SE**

(71) Applicant: **POTTERS INDUSTRIES**
**20 Waterview Boulevard**
**Parsippany New Jersey 07054 (US)**

(72) Inventor: **Schneider, Carrol F.**
**15, Rolling Hill Drive**
**Morristown New Jersey 07960 (US)**

**Teichmann, Robert J.**
**152 Bell Street**
**Belleville New Jersey 07109 (US)**

(74) Representative: **Chanet, Jacques**
**Conseil en Brevets 129 Avenue de Royat B.P. 27**
**F-63401 Chamalières Cédex (FR)**

The title of the invention has been amended (Guidelines for Examination in the EPO, A-III, 7.3).

(54) **Ferrite particle plating system and electromagnetic shielding.**

(57) A particulate magnetic material in which a multiplicity of minute magnetite or other ferrite particles are provided with a conductive metal coating. The coating has a thickness of from about 1% to about 15% of the maximum particle dimension and is about 5% to about 60% by weight of the particle. The coated particles are deposited in a non-conductive matrix such as a spray lacquer film for use as electrode magnetic shielding.

EP 0 354 131 A2

## Description

This invention relates to particulate magnetic material and more particularly to such material for use in a liquid or solid electroconductive matrix, and to a method for producing the material.

### Background Of The Invention

There has been developed a conductive particle which exhibits good electrical and magnetic properties particularly when incorporated in a matrix or substrate. Representative particles of this type are disclosed, for example, in Robert J. Teichmann, U.S. Patent 4,711,814 granted December 8, 1987. The particles are in the form of nickel beads, flakes or other configurations which are coated with one or more noble metals and are embedded in a matrix to provide the matrix with electroconductive properties. The magnetic characteristics of the nickel particles assist in the proper orientation of the particles within the matrix and have other important advantages.

Heretofore, difficulties have been encountered in the manufacture of some of the smaller size coated nickel particles, and these difficulties were of special moment in situations in which the particles were intended for use in conductive spray lacquers and other thin films. In addition, the tendency of the nickel to oxidize has resulted in the need for unnecessarily complex manufacturing techniques. Furthermore, the magnetic permeability of the nickel particles proved deficient for those applications which require particularly good electromagnetic shielding characteristics.

### Summary

One general object of the invention, therefore, is to provide a new and improved particulate magnetic material.

Another object of the invention is to provide a novel method for making electroconductive particles.

A further object of the invention is to provide an electromagnetic shielding material containing such particles.

More specifically, it is an object of this invention to provide a particulate magnetic material of the character indicated in which the individual particles are of extremely small size.

Still another object of the invention is to provide such particles in which there is little or no tendency toward oxidation of the core material of the particles.

A still further object of the invention is to provide a new and improved method for making electroconductive particles which is economical and thoroughly reliable in operation.

In an illustrative embodiment of the invention, a multiplicity of ferrite particles of spherical configuration are thoroughly cleaned and are then coated with a conductive metal in accordance with a carefully controlled coating procedure. The particles may be embedded in a spray lacquer, for example, to provide an electroconductive film.

In accordance with one feature of the invention, the use of ferrite as the core material for the particles greatly facilitates the manufacturing process because the ferrite exhibits little or no tendency toward oxidation. The high magnetic permeability of the ferrite in combination with the excellent electrical conductivity of the metal coating provide extremely effective electromagnetic shielding when the particles are used in polymeric films or other matrices.

In accordance with another feature of the invention, in certain particularly advantageous embodiments, magnetite is used as the ferrite core material for the particles. Magnetite is unusually effective in cases in which the particles are of spherical configuration, and it has other important advantages.

In accordance with a further feature of the invention, in several good arrangements, the size of the ferrite particles is maintained within the range, on average, of between 1 and 250 microns in maximum dimension. Particles within this range provide effective shielding even when embedded in spray lacquers or other film materials having extremely small thicknesses.

In accordance with a further feature of certain embodiments of the invention, the coating on the ferrite particles is a noble metal and has a thickness of from about 0.05 percent to about 15 percent of the maximum particle dimension. The amount of coating material employed advantageously is about 1 percent to about 60 percent by weight of the coated particle. The use of a noble metal coating of this character ensures good electrical conductivity for the particles while maintaining an extremely small particle size. Noble metals useful as coatings include silver, gold, platinum and palladium, although silver is preferred because of its lower cost and ease of application.

The present invention, as well as further objects and features thereof, will be more fully understood from the following description of a preferred embodiment, when read with reference to the accompanying drawing.

### Brief Description Of The Drawing

Fig. 1 is a substantially enlarged vertical sectional view of a magnetic electrically conductive particle in accordance with an illustrative embodiment of the invention.

Fig. 2 is a substantially enlarged fragmentary vertical sectional view of a conductive film incorporating the particles of Figure 1.

## Description Of A Preferred Embodiment

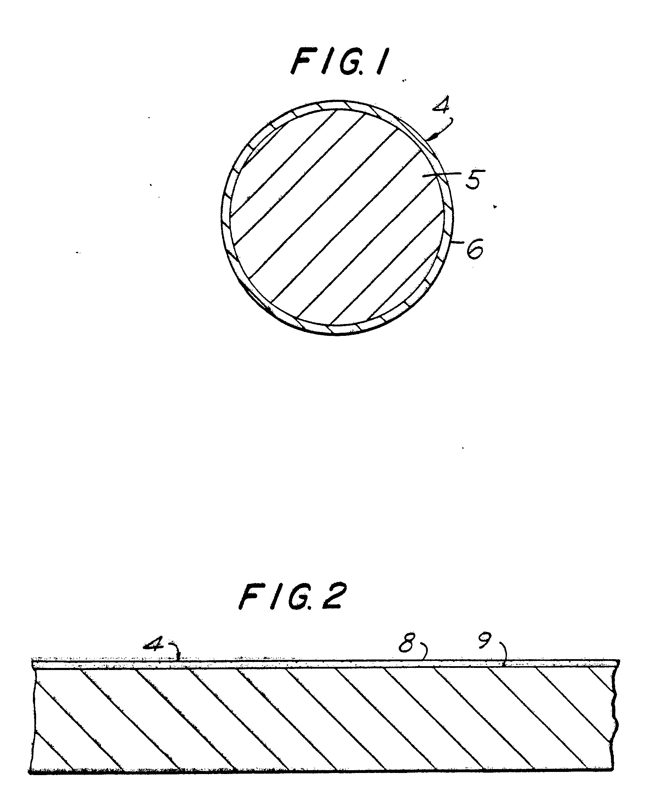

Referring to Fig. 1 of the drawing, there is shown a magnetic electrically conductive solid particle 4 having a ferrite core 5 and a silver coating 6. In the illustrated embodiment the particle 4 advantageously is of bead-like spherical configuration, although in other embodiments the particles may be of irregular or other geometric shapes with good results. The particles are extremely minute and are of a size, on average, of between 1 and 250 microns, and preferably between 5 and 100 microns, in maximum dimension.

Although a wide variety of ferrite materials may be utilized for the core 5, ferrosoferric oxide or magnetite ($Fe_3O_4$) is advantageous particularly in cases in which the particles are of spherical configuration. Magnetite has a lower melting point than some of the other ferrites, and it may be readily spheroidized by heating crushed magnetite particles and directing the particles with the combustion gases along a path until surface tension causes the particles to assume a spherical form.

More specifically, the magnetite ore is spray dried, sintered and then ground to the appropriate particle size. The particles are then introduced into a plasma furnace having a plasma jet torch of the type disclosed in Poole U.S. Patent 4,570,048, for example. The combustion gases from the torch direct the particles along a path for a time sufficient to enable surface tension to cause all of the particles to assume a spherical form. The particles are then subjected to a classification procedure to provide particles of substantially uniform diameter within the range of from 1 to 250 microns. For use in conductive spray lacquers and other thin films, the particle diameter preferably should be maintained below about 100 microns. Particles having diameters above about 100 microns are too large to be used effectively for these applications, although the larger particles may be employed in substrates to provide electrical connectors, for example.

The thickness of the silver coating 6 on the magnetite particle 5 will of course depend on the size of the particle. The silver coating, however, should have a thickness of from about 0.05 percent to about 15 percent of the maximum particle dimension and should be about 1 percent to about 60 percent by weight of the particle. Silver coatings having thicknesses below these ranges are insufficient to provide the particles with the desired electrically and thermally conductive properties. If the amount of silver on the particles exceeds about 15 percent of the maximum particle dimension and about 60 percent by weight of the particle, on the other hand, the overall size of the particle is too great for many applications. For magnetite particles having a size within the above range, the thickness of the silver coating should lie between about 420 angstroms and about 7,000 angstroms for best results.

The following table is illustrative of the relationship between the size of the coated particles and the quantity and thickness of the silver coating:

| Coated Particle Size (microns) | Percent Silver (by weight) | Silver Thickness (angstroms) |
|---|---|---|
| 5 | 10 | 420 |
| 5 | 20 | 940 |
| 5 | 40 | 2350 |
| 10 | 10 | 850 |
| 10 | 20 | 1900 |
| 20 | 10 | 1700 |
| 20 | 20 | 3700 |
| 30 | 10 | 2500 |
| 30 | 20 | 5600 |
| 35 | 12 | 3600 |
| 50 | 10 | 4200 |
| 50 | 20 | 9400 |
| 80 | 5 | 3250 |
| 80 | 10 | 6800 |

Although various techniques known in the art may be employed to apply the silver coating 6 to the magnetite particles 5, particularly good results are achieved through the use of electroless plating. After spheroidization, the magnetite particles are cooled and placed in a container of glass or other non-reactive material. The particles are sensitized by adding an acidic stannous chloride or stannous fluoride solution to the container and vigorously agitating the particles for, say, 15 or 20 minutes. The excess solution is then rinsed off the particles with deionized water.

The thus sensitized magnetite particles are immersed in a suitable silver plating solution and agitated for a period of time sufficient to provide a smooth and uniform silver coating on each particle. The solution illustratively is an aqueous solution of silver nitrate which has been predissolved in ammonium hydroxide. Small quantities of sodium hydroxide and invert sugar, formaldehyde, sodium gluconate or rochelle salt may be added to the solution to further improve the properties of the coating. Other silvering techniques as practiced in the mirror manufacturing industry also may be used to apply the silver coating, with suitable modification to sensitize the ferrite surface.

The coated magnetic particles in accordance with the invention provide an electromagnetic component for a wide variety of electrical devices. Such devices include, inter alia, conductive paste and coatings, conductive adhesives, conductive elastomers, caulking compounds, and films and other materials used for electromagnetic interference shielding. Referring to Fig. 2 of the drawings, for example, there is shown an electromagnetic film 8 containing the coated particles 4 which has been applied to a substrate 9. Typically, the particles are suspended in a suitable spray lacquer or other organic coating material which is deposited on and adheres to the substrate in the form of the film 8. The particles are randomly oriented within the film but are in sufficient proximity with one another to allow the free passage of electrons. Thus, a large number of conductive paths are established through the film.

The amount of particles suspended in the film forming material will depend in part on the thickness of the silver coatings on the particles. In cases where the particles have a relatively low silver content, however, the coated particles should constitute at least about 30 percent, and preferably about 40 percent, by volume of the film. The arrangement is such that the amount of silver incorporated in the film in the form of particle coatings is at least 2.0 percent and not more than 70 percent by weight of the film. Particularly good results are achieved in situations in which the weight of silver in the particles constitutes at least 15 percent by weight of the film.

The silver coated particles also may be incorporated in rather electroconductive bodies such as a conductive paste. As explained in more detail in the above Teichmann U.S. Patent 4,711,814, the conductive paste is made from a methacrylate polymer or other organic binder that serves as a non-conductive matrix and imparts to the paste the proper rheology, including an appropriate consistency for application on a substrate by screening, painting, dipping, etc. Typically, the binder contains one or more resins and one or more solvents to give the paste the desired consistency.

Although silver and other noble metals exhibit particular utility as coating materials in the embodiment of the invention illustrated in the drawings, in other embodiments the coating may be of a non-noble conductive metal. Thus, the ferrite particles may be provided with a nickel or copper coating, for example and in some cases plural coatings of different metals may be employed with good effect.

The following examples are set forth in illustration of the invention and should not be construed as a limitation thereof. Unless otherwise indicated, all parts and percentages given are by weight.

### Example I

Fifty grams of spherical magnetite particles having an average particle size of 35 microns were placed in a glass round bottom flask. The particles were sensitized by adding a solution composed of 0.3 g of stannous chloride which was dissolved in 500 ml of deionized water acidified with hydrochloric acid. After agitation for 20 minutes, the excess stannous chloride was rinsed off, and the following were added to the particles:
400 ml deionized water
10.7 g silver nitrate predissolved in 100 ml deionized water with 18 ml ammonium hydroxide (28% ammonia)
3.3 g sodium hydroxide predissolved in 20 ml water
3.6 g dextrose predissolved in 20 ml water

The mixture was agitated for 20 minutes until all of the silver was depleted. The particles were then rinsed with deionized water and dried.

The silver coated magnetite particles were carefully examined under a microscope and were observed to have a uniform and smooth silver coating on each particle with no uncoated areas of magnetite. The particles were light tan in color and contained 12 percent by weight silver. The thickness of the silver coating was 3,600 angstroms.

### Example II

Fifty grams of spherical nickel-zinc ferrite particles having an average diameter of 80 microns were sensitized in a slurry composed of 0.006 g stannous chloride dissolved in 300 ml of deionized water acidified with hydrochloric acid. The slurry was agitated for 20 minutes and was then rinsed to remove excess stannous chloride. Thereafter, the following were added to the particles:
200 ml deionized water
5 g silver nitrate predissolved in 50 ml deionized water with 8.3 ml ammonium hydroxide
1.4 g sodium hydroxide dissolved in 10 ml water
1.9 g dextrose dissolved in 10 ml water

The above mixture was agitated for 40 minutes by which time most of the silver was deposited on the particles. The particles were removed from the solution, rinsed with deionized water and dried. Each particle was observed to be white in color with a smooth and uniform silver coating around the ferrite core. The particles contained 5 percent by weight silver, and the thickness of the silver coating on each particle was 3,250 angstroms.

### Example III

Fifty grams of spherical magnetite particles having an average diameter of 53 microns were sensitized and rinsed in the manner described in Example I. The following were then added to the particles:
300 ml deionized water
3.7 g silver nitrate predissolved in 100 ml deionized water with 15 ml ammonium hydroxide
2.7 g sodium hydroxide predissolved in 15 ml water
4.6 g dextrose predissolved in 15 ml water

The mixture was agitated for 40 minutes after which all the silver was depleted. The particles were then rinsed and dried and were observed under the microscope to have a smooth and uniform silver coating on each particle. The particles contained 10 percent silver with a coating thickness of 4,200 angstroms.

### Example IV

Fifty grams of irregularly shaped barium ferrite particles were sensitized and rinsed in the manner described in Example I. The following chemicals were then added to the particles:
53 g silver nitrate dissolved in 200 ml deionized water and 90 ml ammonium hydroxide
16 g sodium hydroxide predissolved in 100 ml water
18.5 g dextrose predissolved in 100 ml water

The solution was agitated for 20 minutes with sufficient force to keep the particles from agglomerating, and the particles were then rinsed and dried. The resulting silver coated irregularly shaped barium ferrite particles exhibited a gray color and contained 40 percent by weight silver having a coating thickness of 2,350 angstroms.

Example V

Fifty grams of spherical magnetite particles having an average diameter of 53 microns were sensitized in the manner described in Example I. The particles were rinsed and immersed into an activation solution comprised of 0.5 g palladium chloride dissolved in 10% HCl and agitated for 5 minutes. After rinsing, the material was added to an electroless nickel plating bath composed as follows:
1000 ml deionized water
33 g nickel sulfate
84 g sodium citrate
50 g ammonium chloride
17 g sodium hypophospite
pH 9.5 with ammonia
temperature 90° C
The mixture was agitated 20 minutes after which all the nickel was deposited. The particles were rinsed and dried and observed to have a continuous electrically conductive coating of nickel. The powder was coated with 13% nickel at a thickness of 7,000 angstroms.

Example VI

Fifty grams of spherical magnetite particles having an average diameter of 53 microns were sensitized and activated in the manner of Example V. After rinsing, they were immersed into the electroless copper bath as follows:
2000 ml deionized water
20 g copper sulfate
20 g sodium hydroxide
10 ml formaline
40 g tetrasodium EDTA
4 ppm potassium cyanide
temperature 60° C
The mixture was agitated for one hour after which all the copper was deposited. The particles were rinsed and dried and exhibited a dull salmon color. Upon analysis they were shown to contain 9% copper with a thickness of 4500 angstroms.

Example VII

In each of the foregoing Examples, the metal coated ferrite particles may be combined with a spray lacquer or other matrix. The resulting electroconductive body is applied to a substrate such as a plastic housing for electronic circuitry on aircraft, and enclosures for metal conductors, capacitors, resistors or other electronic components, to serve as a shield from electromagnetic radiation, or is packaged and stored or shipped for subsequent use.

The terms and expressions which have been employed are used as terms of description and not of limitation, and there is no intention in the use of such terms and expressions of excluding any equivalents of the features shown and described, or portions thereof, it being recognized that various modifications are possible within the scope of the invention claimed.

## Claims

1. A particulate magnetic material comprising, in combination:
a multiplicity of ferrite particles having a size, on average, of between 1 and 250 microns in maximum dimension; and
a conductive metal coating on each of the ferrite particles, the coating having a thickness of from about 0.05 percent to about 15 percent of the maximum particle dimension and being about 1 percent to about 60 percent by weight of the particle.

2. A particulate magnetic material comprising, in combination:
a multiplicity of magnetite particles having a size, on average, of between 1 and 250 microns in maximum dimension; and
a silver coating on each of the magnetite particles, the silver coating having a thickness of from about 0.05 percent to about 15 percent of the maximum particle dimension and being about 1 percent to about 60 percent by weight of the particle.

3. A particulate magnetic material as defined by claim 2, in which the thickness of the silver coating on each particle is at least about 420 angstroms.

4. A particulate magnetic material as defined by claim 2, in which the magnetite particles are less than about 50 microns in maximum dimension.

5. A particulate magnetic material for electromagnetic shielding, the material comprising, in combination:
a multiplicity of spherical ferrite particles having a diameter, on average, of between 1 and 250 microns;
a conductive metal coating on each of the ferrite particles, the coating on each particle having a thickness of at least about 420 angstroms and being about 1 percent to about 60 percent by weight of the particle.

6. A particulate magnetic material as defined by claim 5, in which the particles are of nickel-zinc ferrite.

7. A particulate magnetic material as defined by claim 5, in which the particles are of barium ferrite.

8. A method of producing magnetic electrically conductive particles, the method comprising, in combination:
forming a multiplicity of ferrite particles by heating the same to cause the particles to become spherical by surface tension, the thus formed particles having a size, on average, of between 1 and 250 microns in maximum dimension;

cleaning the spheroidized ferrite particles; and applying a silver coating to each of the particles until the thickness of the silver coating is from about 0.05 percent to about 15 percent of the particle diameter, the amount of silver on each particle being about 1 percent to about 60 percent by weight of the particle.

9. A method as defined in claim 8, in which the silver coating is applied by electroless plating the silver on the ferrite particles.

10. A method of producing magnetic electrically conductive particles, the method comprising, in combination:

spheroidizing a multiplicity of ferrite particles by heating the same to cause the particles to become spherical by surface tension, the diameter of the thus spheroidized particles lying within the range of from about 1 micron to about 250 microns;

cleaning the spheroidized ferrite particles; and applying a silver coating to each of the spheroidized ferrite particles until the thickness of the silver coating is from about 0.05 percent to about 15 percent of the particle diameter, the amount of silver on each particle being about 1 percent to about 60 percent by weight of the particle.

11. A method of producing magnetic electrically conductive particles, the method comprising, in combination:

spheroidizing a multiplicity of magnetite particles by heating the same to cause the particles to become spherical by surface tension, the diameter of the thus spheroidized particles lying within the range of from about 1 micron to about 250 microns;

cleaning the spheroidized magnetite particles; and

applying a silver coating to each of the spheroidized magnetite particles until the thickness of the silver coating is from about 0.05 percent to about 15 percent of the particle diameter, the amount of silver on each particle being about 1 percent to about 60 percent by weight of the particle.

12. A method as defined in claim 11, in which the thickness of the silver coating is between about 420 angstroms and about 7,000 angstroms.

13. Electromagnetic shielding comprising, in combination:

a nonconductive organic coating material;

a multiplicity of ferrite particles immersed in the coating material, the ferrite particles being of a size, on average, of between 1 and 250 microns in maximum dimension; and

a conductive metal coating on each of the ferrite particles, the coating having a thickness of from about 0.05 percent to about 15 percent of the maximum particle dimension and being about 1 percent to about 60 percent by weight of the particle.

14. Electromagnetic shielding as defined in claim 13, in which the ferrite particles are of spherical configuration.

15. Electromagnetic shielding comprising, in combination:

a nonconductive organic coating material;

a multiplicity of magnetite particles immersed in the coating material, the magnetite particles being of a size, on average, of between 1 and 250 microns in maximum dimension; and

a silver coating on each of the magnetite particles, the silver coating having a thickness of from about 0.05 percent to about 15 percent of the maximum particle dimension and being about 1 percent to about 60 percent by weight of the particle.

16. Electromagnetic shielding as defined in claim 15, in which the nonconductive organic coating material comprises a spray lacquer.

17. Electromagnetic shielding comprising, in combination:

a nonconductive organic coating material;

a multiplicity of magnetite particles immersed in the coating material, the magnetite particles being of a size, on average, of between 1 and 250 microns in maximum dimension; and

a silver coating on each of the magnetite particles, the silver coating having a thickness of from about 0.05 percent to about 15 percent of the maximum particle dimension and being about 1 percent to about 60 percent by weight of the particle, the amount of silver on the particles immersed in the organic coating material being at least about 2.0 percent and not more than about 60 percent by weight of the coating material.

# FIG. 1

# FIG. 2